(19) 

Europäisches
Patentamt

European
Patent Office

Office européen
des brevets

(11) **EP 1 923 925 B1**

(12) **EUROPEAN PATENT SPECIFICATION**

(45) Date of publication and mention
of the grant of the patent:
**10.02.2010 Bulletin 2010/06**

(51) Int Cl.:
***H01L 41/083*** (2006.01)

(21) Application number: **06255865.5**

(22) Date of filing: **16.11.2006**

(54) **Piezoelectric actuator assembly**

Piezoelektrische Aktuator Einheit

Assemblage d'un actuateur piézo-électrique

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**21.05.2008 Bulletin 2008/21**

(73) Proprietor: **Delphi Technologies, Inc.
Troy, Michigan 48007 (US)**

(72) Inventor: **Goat, Christopher A.,
Offham,
Kent, ME19 5NU (GB)**

(74) Representative: **Gregory, John David Charles et al
Delphi Diesel Systems
Patent Department
Courteney Road
Gillingham
Kent ME8 0RU (GB)**

(56) References cited:
**EP-A2- 1 587 152     DE-A1-102004 006 266**

**Description**

This invention relates to a piezoelectric actuator assembly having a leakage resistor for actuator discharge. In particular, the invention relates to a piezoelectric actuator assembly having a thick film leakage resistor, suitable for use in a fuel injector of a fuel injection system of an internal combustion engine.

It is known to provide a fuel injector for an automotive engine with a piezoelectric actuator for controlling the injection of fuel into the engine. By way of example, our co-pending European patent application EP 1174615 describes a fuel injector in which a piezoelectric actuator is arranged to control movement of an injector valve needle towards and away from a valve seating, so as to control the injection of fuel.

A piezoelectric actuator of the type used in a fuel injector includes a stack of piezoelectric layers (or elements) that are separated by a plurality of internal electrodes. The actuator includes positive and negative external electrodes that respectively connect to alternate internal electrodes, such that positive and negative internal electrodes interdigitate along the length of the piezoelectric stack, with a layer of the piezoelectric material in-between.

In use, an electrical connector having positive and negative terminals provides a voltage to respective positive and negative external electrodes, which produces an intermittent electric field between adjacent interdigitated electrodes. The intermittent electric field can be rapidly varied with respect to its strength, which in turn causes the stack of piezoelectric layers to extend and contract along the direction of the applied field.

Within a fuel injector, the lowermost piezoelectric layer of the stack is adjacent to a lower end cap and the uppermost piezoelectric layer of the stack is adjacent to an upper end cap. The lower end cap is coupled to an injector valve needle, either directly or through an intermediate mechanical and/or hydraulic coupling. Thus, as the stack extends and contracts upon application of the electric field, the injector valve needle is similarly caused to move up and down, in relation to an injector valve seat, to control injection of pressurised fuel into an associated engine cylinder.

In use, fuel is prevented from being injected into the associated engine cylinder when the injector valve needle is securely engaged with its associated injector valve seat. In a de-energise-to-inject injector, such as that in EP 1174615, this is achieved by applying a voltage of approximately 250 V to the positive internal electrodes and approximately 50 V to the negative internal electrodes to give a differential voltage (or potential difference) of approximately 200 V across the electrodes. This level of differential voltage causes an appropriate extension of the piezoelectric stack, such that the injector valve needle remains in contact with the injector valve seat. Since the actual fuel injection event is generally relatively rapid, the fuel injector needle is engaged with its associated valve seat for approximately 95% of the operating cycle of the fuel injector.

To inject fuel into the cylinder the differential voltage across the positive and negative internal electrodes is rapidly reduced, causing the piezoelectric stack to contract. The pressure of the fuel and the amount of fuel that it is intended to inject determines the required level of voltage reduction. For example, at a minimum fuel pressure of around 200 bar (such as when the engine is idling), the voltage applied to the positive internal electrodes may be reduced to approximately 20 V; while at a maximum pressure of around 2000 bar, the voltage applied to the positive internal electrodes may be reduced to approximately -20 V, briefly making the positive internal electrodes negative.

A problem associated with the use of piezoelectric actuators, such as within an internal combustion engine, is that each unit of the piezoelectric stack (consisting of a positive internal electrode, a negative internal electrode and an intervening layer of piezoelectric material), behaves like an electrical capacitor. Hence, the entire piezoelectric stack, which may include hundreds of such electrical capacitors, is therefore able to store a large amount of electrical charge. Moreover, a piezoelectric actuator in good condition is capable of storing this electrical charge for a considerable time, even after the power to the actuator has been shut off.

As a result of such charge build up, there is a risk of accidentally damaging the piezoelectric actuator if it is put under tension by a sudden discharge of the stored charge. Moreover, if the positive and negative terminals of the electrical connector are shorted through inadvertent human contact, e.g. during routine maintenance of the fuel injector, a large and potentially fatal electrical shock could occur.

To prevent either of these two undesirable events the actuator should be discharged in a controlled manner over a short period of time after the electrical supply to the actuator has been removed.

It is known to provide the electrical connector with a "shunt" resistor, connected in parallel across the connector terminals. This resistor provides a leakage path to drain the charge that accumulates within the stack over a relatively long period of time. In other known actuators a resistor is not provided in the electrical connector itself, but is connected in parallel across the stack external electrodes, for example, by welding or soldering, to provide the same charge drain function. However, these strategies can be both prohibitively expensive and prone to failure. See for example EP 1 587 152 or DE 10 2004 006266.

In addition, the resistance of the shunt resistor must be selected as a compromise between safety and efficiency / performance, as the presence of the resistor must not affect the relatively short duration current pulses of normal operation. A further disadvantage of providing a shunt resistor across the stack is that the ability to implement diagnostic monitoring of the injector is compromised as a result of the inevitable leakage current that flows through the shunt resistor. It is important to be able to detect a short circuit in the injector at all times so as to ensure that an appropriate injector control strategy can be implemented to accommodate the fault (for example, to prevent damage to other injectors of the system).

Accordingly, there is a need for a means for the automatic and controlled discharge of a piezoelectric actuator at power supply cessation (e.g. for use in a fuel injection system of an internal combustion engine), which overcomes or alleviates some of the problems associated with the prior art.

Thus, in accordance with a first aspect of the invention, there is provided a piezoelectric actuator assembly for use in a fuel injector, comprising: a piezoelectric actuator; and a leakage resistor; the piezoelectric actuator comprising a positive external electrode, a negative external electrode and a piezoelectric stack; the piezoelectric stack including a plurality of piezoelectric layers, a first population of internal electrodes, and a second population of internal electrodes, wherein the first population of internal electrodes connects to the positive external electrode to create a population of positive internal electrodes and the second population of internal electrode connects to the negative external electrode to create a population of negative internal electrodes, and wherein the positive and negative internal electrodes interdigitate along the length of the piezoelectric stack, with a piezoelectric layer there between; and wherein the leakage resistor comprises a film of electrically resistive material overlying an exposed electrode face of the piezoelectric actuator and in direct contact with at least one piezoelectric layer, positive internal electrode, and negative internal electrode of the piezoelectric stack, such that charge stored across the at least one piezoelectric layer, positive internal electrode, and negative internal electrode is dissipated through the electrically resistive material.

Thus, the film of resistive material is in contact with an exposed electrode face of the piezoelectric actuator. Preferably, the piezoelectric actuator assembly is suitable for use in a fuel injection system (or fuel injector) of an internal combustion engine.

This invention offers a number of advantages: for example, the material is low cost and the resistor is simple to design and manufacture. Since there are no moving parts that could break a resistor comprising a film of electrically resistive ink is also highly reliable compared with some other forms of resistor.

In accordance with a second aspect of the invention there is provided a method for constructing a piezoelectric actuator assembly having a leakage resistor suitable for use in a fuel injector of an internal combustion engine, which comprises: providing a piezoelectric stack, the piezoelectric stack including a plurality of piezoelectric layers separated by a plurality of internal electrodes, and having an exposed electrode face; printing a layer of electrically resistive ink onto the surface of the exposed electrode, the electrically resistive ink comprising an electrically resistive material and an organic liquid (vehicle or dispersant); and heating to evaporate the organic liquid, thereby forming a film of electrically resistive material.

Preferably the heating is such that the electrically resistive material is sintered and bonded to the exposed electrode face of the piezoelectric stack.

The manufacture of a resistor using an electrically resistive ink also offers a number of advantages. For example, manufacture of the film resistor can be carried out using commercially available printing equipment, and potentially the piezoelectric actuator supplier itself can manufacture the piezoelectric actuator assembly ready prepared with the film of resistive material. In addition, development costs may be greatly reduced, because known thick film manufacturing technology may be used. Furthermore, to change the resistance of the film of electrically resistive material it is only necessary to use a new printing screen.

Typically, a resistor made from a film of electrically resistive material, for example, using known thick film printing technology, will have a thickness of from 10 to 25 $\mu$m thick, and more preferably from 15 to 20 $\mu$m. It will be appreciated that thicknesses of less than 10 $\mu$m or more than 25 $\mu$m are also possible. The invention provides the advantage that by trimming the film of electrically resistive material, for example, using commercially available equipment, the thickness of the film can be accurately reduced, and thus, the resistance of the film can be tightly controlled. For example, the film may be accurately trimmed to give a film of predetermined thickness, or in the alternative, the film may be precisely trimmed to produce a film of predetermined resistance. Preferably, the film is trimmed, if necessary, to achieve a film of the required resistance.

In a preferred embodiment the film of electrically resistive material has a resistance of approximately 1 M$\Omega$.

So as to reduce the size of the printed film on the surface of the piezoelectric actuator, it is advantageous that the electrically resistive material has a resistivity of at least 5 G$\Omega$ and preferably approximately 10 G$\Omega$.

Preferably, the resistive material of the electrically resistive ink has a low temperature coefficient of resistivity of approximately 0.0001/°C (i.e. 100 ppm/°C). Such a low temperature coefficient of resistivity means that the resistance of the film of electrically resistive material will remain relatively stable over the normal operating temperatures of the piezoelectric actuator.

Suitable electrically resistive inks (or pastes), therefore, beneficially comprise a resistive material selected from a ruthenium compound. Preferably, the ruthenium compound is selected from barium ruthenate, bismuth ruthenate, and ruthenium oxide. More preferably, the ruthenium compound is ruthenium oxide.

The ink preferably further comprises an organic liquid (vehicle or dispersant). More preferably the ink further comprises glass frit. Optionally the ink also comprises a resin.

In view of: the desired resistance of the film; the inherent resistivity of the resistive ink (or material); and the thickness of the film, the film of electrically resistive ink (or material) is preferably printed onto an area of 60 to 100 mm$^2$. This is the area of contact between the film of resistive material and the exposed electrode face of the piezoelectric actuator. More preferably, the film of electrically resistive material has an area of approximately 81 mm$^2$. In practice, however, the resistor can be any size suitable to fit on an exposed electrode face of an actuator. In general, the larger the resistor, the easier it is to trim and the less is the localised heating of the resistor when charge is dissipated.

A typical piezoelectric actuator for use in a fuel injection system of an internal combustion engine is described in European patent application EP 1 516 373, for example. This piezoelectric actuator has a width and depth of approximately 7.8 mm, however, the corners are chamfered, creating an octagonal cross section and an exposed electrode face of approximately 5 mm wide. The length of the piezoelectric actuator is approximately 80 mm. Along the length of this actuator the separation of adjacent positive and negative internal electrodes of the piezoelectric stack is approximately 90 $\mu$m.

Conveniently, therefore, the film of electrically resistive ink (or material) may be printed as a rectangle of approximately 4.5 mm width and approximately 18 mm length. The important factor being, however, the total contact area between the film and the exposed electrode face of the actuator.

Preferably, the power generated by the dissipation of the charge stored within the piezoelectric actuator across the electrically resistive material is approximately 0.5 mW/mm$^2$. As such, the dissipation of charge should not cause the area of piezoelectric actuator that is in contact with the film, nor the film itself, to heat to a temperature that could cause damage to either the actuator, the film, or both.

The piezoelectric actuator assembly for use in accordance with the invention, typically further comprises a positive and a negative actuator terminal connectable to the positive and negative external electrodes, respectively, and which are capable of receiving an electrical signal from a power supply means.

Preferably, the piezoelectric actuator, or at least the piezoelectric stack thereof, is coated in a passivation and encapsulation material, for example, in the form of a polymeric sheath. This provides the advantage that, in use, the piezoelectric stack and the film of electrically resistant material are protected from the engine bay environment, including any fuel within the fuel injector.

In a preferred embodiment of the invention, the piezoelectric layers of the piezoelectric actuator are formed of lead zirconate titanate (PZT).

The piezoelectric actuator assembly of the invention is suitable for use in a fuel injector for a compression ignition internal combustion engine. By way of example, our co-pending European patent application EP 1174615 describes a fuel injector in which a piezoelectric actuator controls movement of an injector valve needle to control the injection of fuel into the engine.

Thus, the invention also relates to a fuel injector for use in an internal combustion engine, comprising a valve needle for controlling injection of fuel into the engine and a piezoelectric actuator assembly as described herein for controlling movement of the valve needle.

It will be appreciated that the methods for constructing a piezoelectric actuator assembly according to the second aspect of the invention encompass the methods necessary to construct a piezoelectric actuator assembly having any of the preferred and/or optional features of the actuator assembly of the first aspect of the invention, in any appropriate combination. In addition, it will be appreciated that the fuel injector of the invention includes any fuel injector that comprises a piezoelectric actuator assembly in accordance with the first aspect of the invention, or that was made by a method in accordance with the second aspect of the invention.

The invention will now be described, by way of example, with reference to the accompanying drawings in which:

Figure 1 is a schematic diagram of a piezoelectric actuator of the type used in the present invention;

Figure 2 is a schematic diagram of an upper end of a piezoelectric actuator similar to that shown in Figure 1 illustrating positive and negative terminals of the actuator;

Figure 3 is a schematic diagram of a fuel injector for an internal combustion engine of the type in which the piezoelectric actuator of Figure 2 may be employed;

Figure 4 is a schematic diagram of a piezoelectric actuator assembly of the invention having a film of an electrically resistive material printed onto an exposed electrode face;

Figure 5 is a schematic representation of the relationship between the size of a film resistor (volume, panel A; and surface area, panel B) and its resistance;

Figure 6 is a schematic representation of the relationship between the effective resistance of a film resistor and its surface area of contact with a piezoelectric actuator as shown in any of Figures 1 to 4;

Figure 7 is a graph showing the relationship between the resistance of a film of an electrically resistive material of fixed resistivity and its surface area of contact with an exposed face of a piezoelectric actuator;

Figure 8 is a graph showing the relationship between the resistivity of a film resistor and its surface area of contact with an exposed face of a piezoelectric actuator for a 1MΩ resistor.

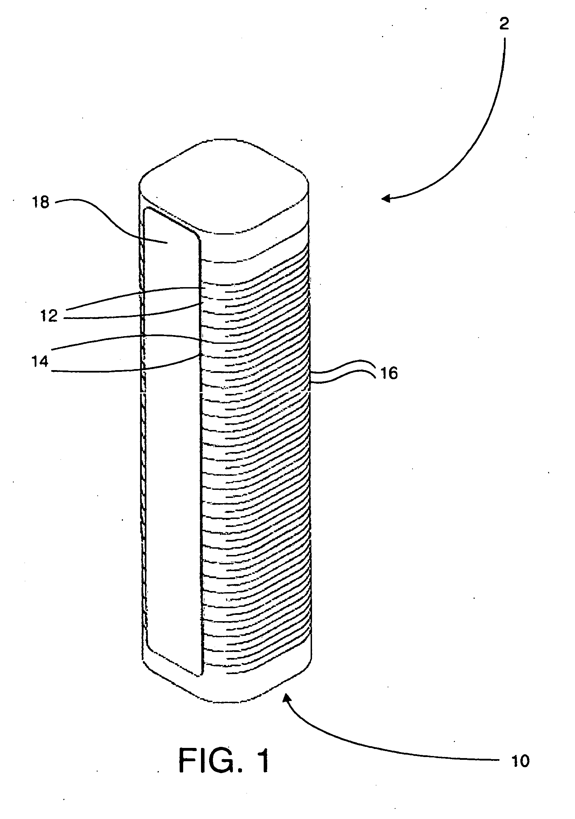

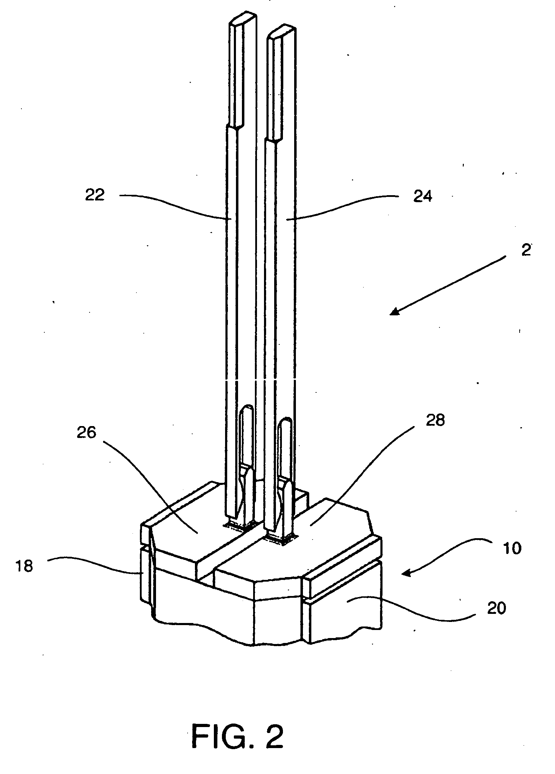

Referring to Figures 1 and 2, a piezoelectric actuator 2 has a piezoelectric stack structure 10 formed from a plurality of piezoelectric layers or elements 12 (only two of which are identified) separated by a plurality of internal electrodes, of which a first population of internal electrodes are identified at 14 (only two of which are identified) and a second population of internal electrodes are identified at 16 (only two of which are identified). Figure 1 is illustrative only and in practice the stack structure 10 would include a greater number of layers and electrodes than those shown and with a much smaller spacing. The first population of internal electrodes 14 are connected to a positive external electrode 18, and so may also be referred to as "positive internal electrodes". The second population of internal electrodes 16 are connected to a negative external electrode 20, on the opposite side of the stack 10 to the positive external electrode 18 (shown only in Figure 2), and so may be referred to as "negative internal electrodes". The positive internal electrodes 14 are interdigitated with the negative internal electrodes 16.

The piezoelectric actuator 2 of Figure 2 is provided with a positive actuator terminal 22 and a negative actuator terminal 24 at its upper end, which connect with the positive external electrode 18 and the negative external electrode 20, respectively. In the actuator shown, base connector plates 26, 28 at the upper end of the stack 10 provide an electrical connection between the external electrodes 18, 20 and the respective actuator terminals 22, 24.

Typically, the piezoelectric material from which the piezoelectric layers 12 are formed is a ferroelectric material such as lead zirconate titanate, also known by those skilled in the art as PZT. The actuator construction results in the presence of active regions between internal electrodes of opposite polarity; i.e. the smallest active region or unit consists of one positive internal electrode, one negative internal electrode and the piezoelectric layer inbetween those electrodes. In use, when a voltage is applied across the external electrodes, the active regions are caused to expand resulting in an extension of the stack length along the direction of the applied field. When the voltage is removed, the stack length is caused to contract.

By incorporating a piezoelectric actuator such as that of Figure 2 into a fuel injector, the injection of fuel into a corresponding engine cylinder can be controlled.

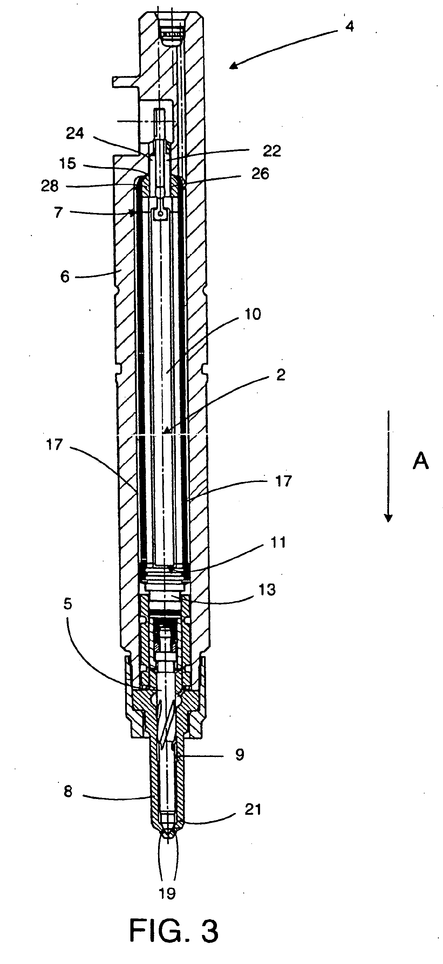

Referring to Figure 3, a fuel injector 4 includes an injector body 6 and an injector valve nozzle 8. The injector body 6 has a bore 7 that houses a piezoelectric actuator 2, and the injector valve nozzle 8 has a bore 9, in alignment with the bore 7, that houses an injector valve needle 5. In use, the bores 7, 9 also contain fuel to be injected into an engine cylinder, and therefore, it is preferable to shield the piezoelectric actuator 2 from its environment using a passivation and encapsulation layer or barrier 17, for example, in the form of a polymeric sheath.

At the upper end of the piezoelectric stack 10 are connector plates 26, 28, which connect to respective actuator termini 22, 24 for receiving an electrical input from an electrical source (not shown). The connector plates 26, 28 abut the top surface 15 of the bore 7 of injector body 6, such that on receiving an electrical signal, the piezoelectric stack 10 can only expand in the direction of the arrow A.

The lower end 11 of the piezoelectric stack 10 is coupled to the injector valve needle 5 through a coupling means 13, such that any extension or contraction of the piezoelectric stack 10 causes a corresponding upwards or downwards movement of the injector valve needle 5.

By controlling the voltage across the piezoelectric stack 10, and so varying the stack length, the injector valve needle 5 of the injector 4 is moved towards and away from an injector nozzle seating 21 to control injection into the associated engine cylinder (not shown). Typically, the voltage across the piezoelectric stack 10 is controlled by means of an engine control unit (ECU) (also not shown).

In order to prevent injection of fuel into the cylinder, the injector valve needle 5 securely abuts the injector nozzle seating 21; thereby preventing fuel from passing through fuel outlet channels 19 in the nozzle 8. This is achieved by applying a differential voltage of e.g. 200 V across the positive and negative internal electrodes 14, 16 (not shown) to cause the piezoelectric stack 10 to extend in the direction of arrow A. As previously mentioned, the fuel injector needle 5 is engaged with the associated injector nozzle seating 21 in the aforementioned manner for approximately 95% of the operating cycle of the fuel injector.

When a fuel injection into the associated engine cylinder (not shown) is required the differential voltage across the positive and negative internal electrodes 14, 16 is rapidly reduced, for example, to 20 V, thus causing the piezoelectric stack 10 to rapidly contract. Once the injector valve needle 5 has lifted from the injector nozzle seating 21, fuel from within the bores 7, 9 can flow past the space between the injector valve needle 5 and the injector nozzle seating 21 and out through the fuel outlet channels 19.

The amount by which the differential voltage across the positive and negative internal electrodes 14, 16 is reduced is dependent on the pressure of the fuel within the fuel injector 4. Since the pressure of fuel may, in normal operating conditions, vary between 200 bar and 2000 bar, the differential voltage applied across the positive and negative internal electrodes 14, 16 will typically be reduced by about 40 V.

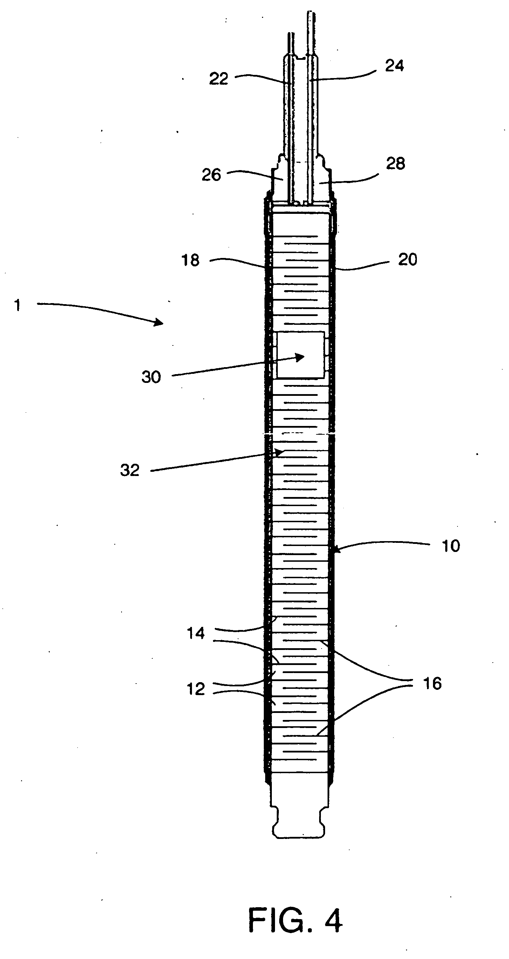

An embodiment of the piezoelectric actuator assembly 1 of the invention is shown in Figure 4. With respect to the piezoelectric actuator, like reference numerals are used to denote equivalent parts to those of the piezoelectric actuator described in Figures 1 and 2.

As shown, the piezoelectric stack 10 includes a plurality of piezoelectric layers or elements 12, a plurality of positive internal electrodes 14 and a plurality of negative internal electrodes 16. The positive internal electrode 18 and the negative internal electrode 20 abut two opposing sides of the piezoelectric stack 10. Hence, the further two opposing sides of the piezoelectric stack 10 are exposed electrode faces 32 (only one of which is visible). A leakage resistor in the form of a film of electrically resistive material 30 is printed (as an ink) and fired (by heating) over a portion of the exposed electrode face 32. The resultant film of electrically resistive material 30 is in direct contact with at least one piezoelectric layer 12, at least one positive internal electrode 14, and at least one negative internal electrode 16 of the piezoelectric stack 10.

As mentioned, the electrically resistive ink can comprise any appropriate resistive material that has a suitable resistivity, such as barium ruthenate, and ruthenium oxide, provided that the composition of the final film has a suitable resistance. Suitable high-resistive materials are known in the art. Most preferably, the electrically resistive material is ruthenium oxide.

In use, when a differential voltage is applied across the positive and negative internal electrodes 14, 16 a potential difference is created across each piezoelectric layer 12, which results in charge separation and storage similar to that in a capacitor. Were the film of electrically resistive material 30 contacts a pair of adjacent positive and negative internal electrodes 14, 16, stored charge is slowly dissipated across the resistive material, which tends to eliminate the charge stored within the piezoelectric stack 10.

The resistance of the film of electrically resistive material 30 determines the rate at which the stored charge dissipates to zero, and therefore, the size of the film of electrically resistive material and the composition of the ink /material (which affects resistivity etc.) are relevant, as will be explained below.

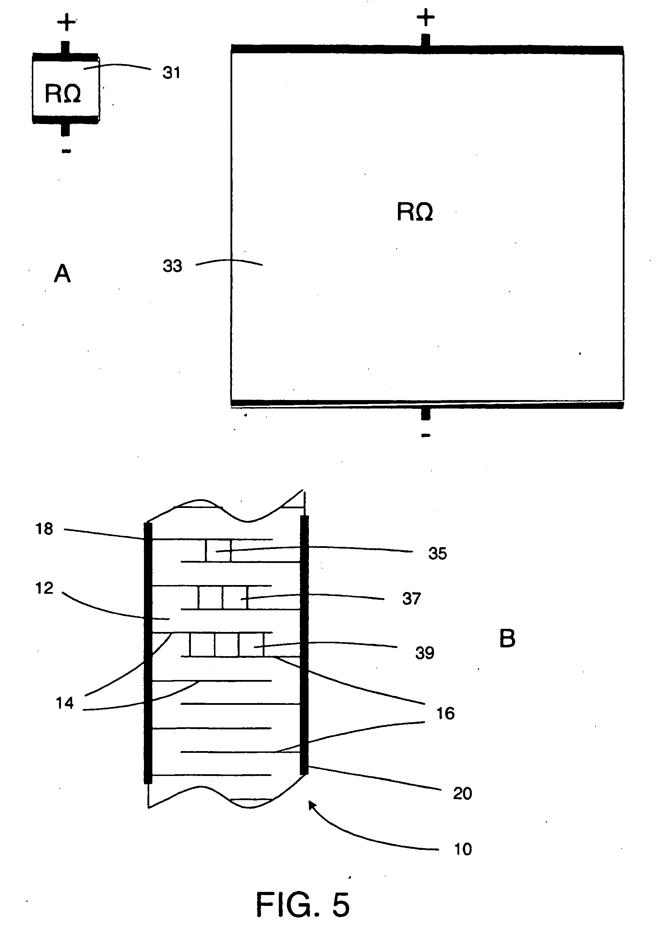

Referring to Figure 5, in thick film resistors, resistance in often quoted in Ohms/square ($\Omega$/square), which is the resistance of a square of fired ink (i.e. the resistive material) of a specified thickness. The reason for this is that a square of any size of a specified thickness has the same resistance (see panel A). Thus, the small square film 31 of electrically resistive material has exactly the same resistance (R$\Omega$) between the positive and negative internal electrodes as the large square film 33 of the same electrically resistive material, provided that both squares have the same thickness.

Therefore, the resistance of a square of electrically resistive material can be accurately adjusted by changing the thickness of the film. For example, if the thickness of a film is reduced by 50%, then the resistance of the film will double.

Figure 5, panel B shows a piezoelectric stack 10 having films of electrically resistive material 35, 37, 39 of three different sizes. For simplicity, each film 35, 37, 39 contacts one positive internal electrode 14, one negative internal electrode 16 and one piezoelectric layer 12 only. This can be considered to represent the smallest active unit of a piezoelectric stack 10 in a piezoelectric actuator. However, it will be appreciated that in a piezoelectric actuator assembly according to the invention, a leakage resistor in the form of a film of electrically resistive material is likely to contact a plurality of such units.

As depicted, provided the films of electrically resistive material 35, 37, 39 are formed of the same material and have the same thickness, then the resistance of each film is inversely proportional to its surface area. Thus, if the resistance of film 35 is R$\Omega$, the resistance of film 37 will be R$\Omega$/2 and the resistance of film 39 will be R$\Omega$/3.

Therefore, it follows that the net resistance of a film of electrically resistant material can be calculated using simple geometry.

There are a number of factors that should be considered when determining the optimal size for a leakage resistor comprising a film of electrically resistive material.

First, it should be considered that charge dissipation across the film generates power that will be emitted as heat. The smaller the surface area of the resistor, the greater the localised heating will be. Such localised heating could adversely affect the performance and durability of the underlying piezoelectric material (e.g. PZT), and could degrade the overlying polymer passivation and encapsulation material, where used. This consideration favours a relatively large surface area film.

In this regard, typically the heat generated internally by an operating piezoelectric actuator due to dielectric loss involves power dissipation of approximately 10 mW/mm$^2$, which is lost through the passivation and encapsulation material (where present). It is desirable that the power dissipated through a film leakage resistor according to the invention is less than 10 mW/mm$^2$, more preferably less that 5 mW/mm$^2$, less than 2 mW/mm$^2$. or less that 1 mW/mm$^2$. Most preferably the power dissipated through a film leakage resistor according to the invention is between 0.25 and 0.75

mW/mm$^2$, for example, approximately 0.5 mW/mm$^2$.

A second consideration that favours a relatively large surface area film is the available manufacturing equipment and techniques that may be used in thick film printing. In this regard, the leakage resistor should preferably be large enough in area to ensure a repeatable baseline resistance can be achieved (when required) by the manufacturing process; for example, using techniques of printing, firing and trimming that are known to the person of skill in the art.

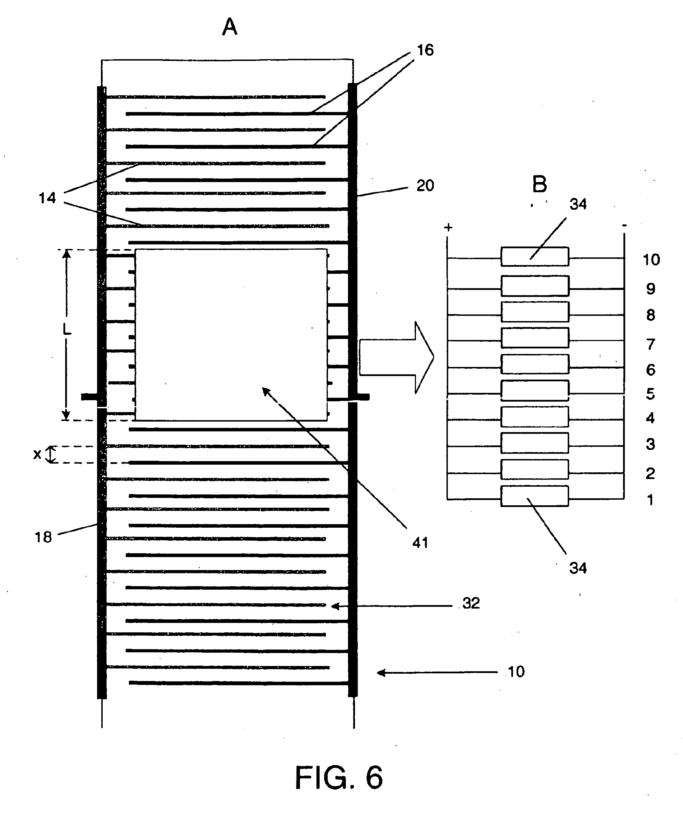

A consideration that favours a relatively smaller surface area film of electrically resistive material is the actual inter-electrode pitch of the internal electrodes of a typical piezoelectric actuator. For example, the inter-electrode pitch (i.e. the distance between adjacent positive and negative internal electrodes) of the piezoelectric actuator in Figure 4 is approximately 90 μm. The larger the film of electrically resistive material the greater the number of pairs of positive and negative internal electrodes it will contact, each of which has a resistor related leakage path across it. In fact, all of the inter-electrode gaps that are bridged by the film become the equivalent of parallel resistors, as indicated in Figure 6.

Referring to Figure 6A a square film 41 of an electrically resistive material is printed onto the exposed electrode face 32 of a piezoelectric stack 10, having a pitch x between adjacent positive internal electrodes 14 and negative internal electrodes 16. As depicted, if the pitch x is 90 μm and the square film 41 has a length L of between 900 and 990 μm (0.9-0.99 mm), then the square film 41 bridges ten pairs of adjacent positive and negative internal electrodes 14,16 (i.e. ten inter-electrode gaps). As indicated in Figure 6B, this is the equivalent to having a discharge circuit of ten parallel resistors 34 of the same resistance.

As the person of skill in the art will appreciate, the total resistance $R_{total}$ of a group of n parallel resistors is calculated according to the equation:

$$1/R_{total} = 1/R_1 + 1/R_2 + 1/R_3 + 1/R_4 \ldots + 1/R_n$$

Hence, the larger the film of electrically resistive material (i.e. the more inter-electrode gaps that it bridges) the lower is its total resistance, and therefore, the higher its Ω/square resistivity must be to achieve a predetermined resistance value.

Advantageously, the film of electrically resistive material has a resistance value that provides the best compromise between undesirably allowing the piezoelectric actuator to discharge too rapidly, which may cause damage to the device, and undesirably causing the stored charge to discharge too slowly, which may not serve a desired purpose of avoiding the risk of injury to a human during maintenance and so on. Thus, the film of electrically resistive material may have a resistance of between 0.25 and 4 MΩ, preferably between 0.5 and 2.0 MΩ, more preferably between 0.75 and 1.5 MΩ, still more preferably between 0.9 and 1.25 MΩ, and most preferably approximately 1 MΩ.

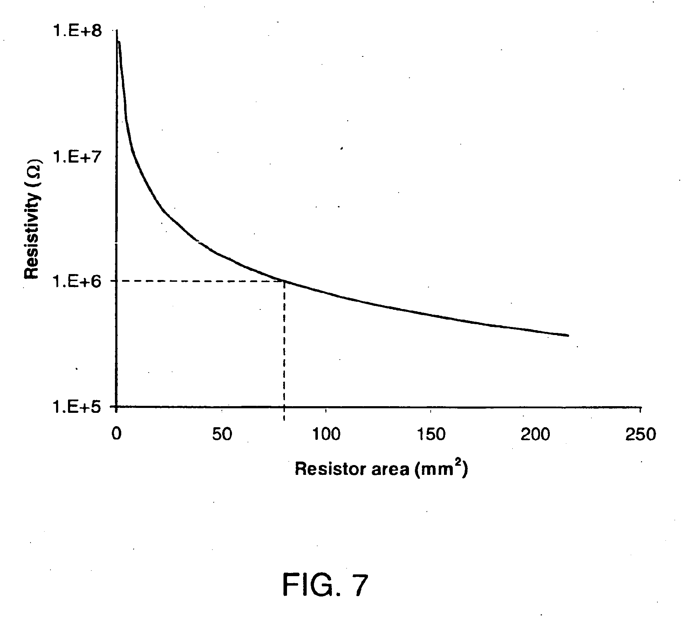

Figure 7 shows the relationship between the resistance of a film resistor of 10 GΩ/square fixed resistivity and its surface area of contact with the piezoelectric actuator in figure 4.

As indicated, the larger the area of the film of electrically resistive material (x-axis) the lower is its total resistance (y-axis) for a given ink / material resistivity. Also, the total resistance of such a film does not depend on its aspect ratio, but merely on its total area. This is because any change in resistance between any single pair of adjacent electrodes, which could be caused by increasing or decreasing the width of the film resistor across a particular inter-electrode gap, will be balanced by an opposing change in the total resistance of the film resistor that would be caused by a concomitant increase or decrease in the number of inter-electrode gaps that are bridged as the length of the film resistor changes proportionally.

From the graph of Figure 7 it can also be seen that for a resistive material of 10 GΩ/square fixed resistivity and a desired total resistance of 1 MΩ, it is necessary to print a film of approximately 81 mm$^2$. Of course, the exact relationship between size and resistance of a film only exists for a particular thickness, so by changing the thickness of the film its resistance can be made to change accordingly. The thickness of the film can be varied in production, as previous discussed, but preferably the film of electrically resistive material is 15-20 μm thick when fired.

Preferably, when the film is to be used as a leakage resistor for a piezoelectric actuator assembly suitable for use in a fuel injector of an internal combustion engine, the area of the film is between 60 and 100 mm$^2$, preferably between 70 and 90 mm$^2$, and more preferably about 79, 80, 81, 82 or 83 mm$^2$. Most preferably, the film is approximately 81 mm$^2$. These sizes are also convenient for enabling the standardisation of manufacturing procedures and allowing good reproducibility and control of film resistance.

From the description herein, it will be appreciated, however, that the size of the leakage resistor is not critical to the performance of the invention; it depends on a number of factors such as the resistivity of the film of electrically resistive material, the desired resistance of the resistor, and the specifications of the relevant piezoelectric actuator stack (e.g. inter-electrode pitch), by way of example. Thus, in alternative embodiments, the film of electrically resistive material may contact the exposed face of the piezoelectric stack over an area of up to 200 mm$^2$. For example, the film may have an area of 4 to 100 mm$^2$ or 8 to 100 mm$^2$.

For different applications and/or for use with different piezoelectric stacks the preferred area of the film may be somewhat different to those mentioned above. However, a suitable area of film can readily be calculated as illustrated herein. By way of example, where an electrically resistant material formed from a resistive ink has a resistivity of 1 GΩ/square (such as for many commonly available inks), with all other variables the same as in the above-discussed preferred embodiment, the film would preferably have an area of approximately 8 mm$^2$.

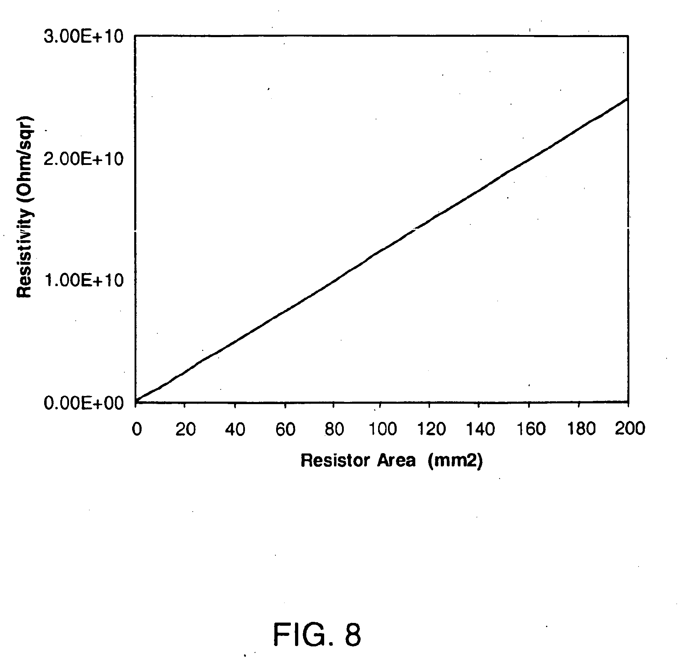

Figure 8 demonstrates the effect of changes in the surface area of contact between a film of electrically resistive material and the exposed face of the piezoelectric actuator in Figure 4 on the resistivity of the material that is required to generate a 1 MΩ leakage resistor.

The graph shows that for a film of approximately 81 mm$^2$, the material should have a resistivity of approximately 10 GΩ/square so as to produce a 1 MΩ resistor.

As indicated above, for a particular piezoelectric actuator and a particular use, it is the overall area of the film of electrically resistive material that is of primary importance, rather than the shape of the film. Therefore, the film could be circular or oval or any other shape. However, it is beneficial for the shape to be suitable for the printing technology that would be used in the construction of the piezoelectric actuator assembly. Accordingly, square and rectangular films are preferred.

For a piezoelectric actuator having an exposed electrode face 5 mm wide (i.e. across the width of the stack), a suitable 81 mm$^2$ film would be rectangular and have preferred dimensions of 4.5 mm wide and 18 mm long (i.e. in the longitudinal axis of the piezoelectric stack). Alternative configurations are also applicable, however, such as approximately 4 mm wide and approximately 20.25 mm long, although the composition or thickness of the film may be adjusted to create the desired resistance.

It has been calculated that the power generated by charge dissipation through an 81 mm$^2$ film leakage resistor of 1 MΩ with 200 V across it (such as in normal use of a piezoelectric actuator assembly of the invention), is approximately 0.5 mW/mm$^2$. As mentioned above, this power output equates to approximately 1/20$^{th}$ of the heat generated internally by an operating piezoelectric actuator due to dielectric loss through the passivation and encapsulation barrier or sheath (i.e. approximately 10 mW/mm$^2$). This extra power output in the area of the film of electrically resistive material should not have a significant effect on local temperatures, nor should it exacerbate degradation of the piezoelectric layers or the polymers of the passivation and encapsulation sheath.

A further consideration when selecting a suitable resistive material from which to form an electrically resistive ink is the temperature coefficient of resistivity of the material. This represents the effect that a change in the temperature of the material will have on its resistivity (and hence, on the total resistance of the resistor constructed with that material). It is preferable, therefore, that the electrically resistive material in the electrically resistive ink has a low temperature coefficient of resistivity. Preferably, the material has a temperature coefficient of resistivity of less than 0.001/°C (i.e. 1000 ppm/°C), more preferably less than 0.0005/°C, less than 0.0003/°C or less than 0.0002/°C. Most preferably, the material has a temperature coefficient of resistivity of approximately 0.0001/°C (i.e. 100 ppm/°C).

The resistance of a film resistor containing as the electrically resistive material, ruthenium oxide, which has a temperature coefficient of resistivity of approximately 0.0001/°C, will change by only approximately 2% over the entire operating temperature range of a typical piezoelectric actuator within a fuel injector of an internal combustion engine. As the skilled person in the art will appreciate, such a small change in resistance will not adversely affect the performance of the leakage resistor.

A non-limiting example of a method of constructing a piezoelectric actuator assembly according to the invention will now be described.

Advantageously, a film of an electrically resistive ink is printed onto an exposed electrode face of a piezoelectric actuator (or piezoelectric stack) using commercially available thick film printing equipment (screen printers, curing ovens or furnaces, laser trimmers etc.), and methodology known to the person of skill in the art, for example, as described in Thick-Film Technology and Applications by M.R. Haskard & K. Pitt, ISBN 0 901150 35 5, ISBN 0 901150355.

First, an electrically resistive ink or paste suitable for printing is manufactured. Thick film inks and pastes consist of a suspension of particulate material with the desired electrical properties (i.e. the electrically resistive material) in an organic liquid, vehicle or dispersant. A resin may be included for viscosity modifications, and other minor constituents may also be added to enhance printability or to adjust the resistivity of the ink. Glass frit is usually also added to the mixture to improve bondability to the surface (i.e. the exposed electrode face of the piezoelectric stack).

Accordingly, a preferred ink for use in accordance with the invention is a mixture comprising at least fine particulate ruthenium oxide, fine particulate glass an organic vehicle and optionally a resin as mentioned above. In some cases the resin may be used as a substitute for the organic vehicle.

It will be appreciated that there are no strict limits to the concentration of the electrically resistive material that should be used to form the ink, or of the further components, provided that the resultant ink has suitable characteristic for its intended use.

Typically ruthenium oxide, or other electrically resistive material mentioned herein, is used in an amount up to 50 %, for example, from 5 to 40 % by weight or 10 to 30 % by weight of the liquid ink. The concentration of electrically resistive material in the ink is chosen according to the inherent resistivity of the material, and the intended total resistance of the film of resistive material. Thus, for a very high resistivity material the concentration of material may be up to 15 wt%, e.g. 1, 2, 3, 4, 5, 6, 7, 8,9,10, 11, 12, 13, 14 or 15wt%. Alternatively, for a lower resistivity material the concentration of material may be up to 50 wt%, e.g. 30, 32, 34, 36, 38, 40, 42, 44, 46, 48, or 50wt%.

The particle size of the ruthenium oxide (or other electrically resistive material) is typically less than 5 μm, more preferably less than 3 μm or less than 2 μm and most preferably 1 μm or less.

Suitable organic vehicles or dispersants are known to the person of skill in the art, and typically include tridecanol, butyl carbitol acetate, and alpha-terpineol. Preferably, the organic vehicle is alpha-terpineol. The organic vehicle may comprise from 10 to 50 % by weight, and preferably from 10 to 30% by weight or 15 to 25 % by weight of the liquid ink.

An example of a suitable resin for use in forming an ink or paste is ethyl cellulose. Other suitable resins will be known to the person of skill in the art. When used the resin may comprise from 10 to 30 % by weight of the liquid ink, depending on its required properties.

The glass should have a high melting point, but should not, of course, melt at a higher temperature than the desired firing temperature of the ink. The glass particles (frit) may be silicate-lead glass, borosilicate glass, borosilicate lead glass, and crystallized glass. Preferably the glass is a silica glass. When used, the glass comprises 10 to 50 % by weight, and preferably from 10 to 30% by weight or 15 to 25 % by weight of the liquid ink. The particle size of glass is preferably less than 5 μm, more preferably less than 2 μm and most preferably 1 μm or less.

In addition to the electrically resistive material, such as ruthenium oxide particles, the ink may further include one or more electroconductive compounds in the form of fine particles of an oxide filler. Oxide fillers include zirconium oxide, titanium oxide, silicon dioxide, aluminum oxide, sodium oxide, calcium oxide and lead oxide. Other oxide fillers will be known to the person of skill in the art. In some embodiments more than one oxide filler may be included in the resistive ink. For example, silicon dioxide and lead oxide may both be included.

Finally, the electrically resistive ink may include other metals, which help to adjust the overall resistivity of the electrically resistive ink. These metals may, for example, include copper, chromium and manganese. Preferably, when used, the concentration of these components is less than 1% by weight, more preferably less than 0.5% by weight or less than 0.25% by weight of the solid film of electrically resistive material. When ink having a high resistivity is required, for example, a resistivity of approximately 10 GΩ/square, the above-mentioned metals, and particularly copper and chromium, are preferably not included.

Having made a suitable ink that meets the desired properties of *inter alia* rheology and resistivity, the leakage resistor can then be formed on an exposed electrode face of a piezoelectric stack.

Prior to printing of the thick film it is beneficial to ensure that the surface onto which the electrically resistive ink is to be printed, i.e. the exposed electrode face of the piezoelectric stack is clean and free from oils, or other surface contaminations, including any surface oxide. For instance, a contaminating surface oxide could affect the resistance value of the leakage resistor. The exposed electrode face may, for example, be cleaned using a standard microetch process, which is used to ensure good bonding between the ink /material and the substrate. The skilled person will, however, appreciate that numerous alternative processes are possible.

The next step is the screen-printing of the electrically resistive ink onto the exposed electrode face using, for example, a standard screen printer. A suitable printer may have a vision system for registration purposes. Typically, the film of electrically resistant ink is applied in such a thickness that, once cured, it will have a thickness of 10 to 25 μm, and more preferably of 15 to 20 μm. To help ensure a consistent resistance value between different actuator assemblies, the rheology of the ink should be such that it enables good paste transfer, and results in a film with even and straight side edges.

The next step is to fire the film of electrically resistive ink, which can be carried out using any suitable equipment, for example, a box oven, a conventional belt furnace or an infra-red (IR) furnace. Typically, the ink is dried with an IR belt drier at about 125°C to remove solvent. The film is then fired to a temperature of approximately 850°C. The whole process of drying and firing typically takes approximately one hour. It will be appreciated that other firing conditions known to the person of skill in the art may be suitable. Typically, firing is carried out in air (unless the ink contains copper). In this regard, preferably the ink does not include copper.

The firing process initially removes the organic vehicle from the electrically resistive ink to leave the particulate matter, e.g. the electrically resistive material (such as ruthenium oxide) and other components, such as glass, that are not volatile at the firing temperature. Further firing of the film then forms a homogeneous mixture of molten glass containing particles of the electrically resistive material, e.g. ruthenium oxide. On cooling, the glass solidifies to form a film of the ruthenium oxide particles.

After the firing process is complete, the film is preferably trimmed using standard equipment, such as a laser trimmer, to produce a film of exactly the desired thickness, for example, of between 15 and 20 μm.

**Claims**

1. A piezoelectric actuator assembly (1), comprising:

   a piezoelectric actuator (2); and
   a leakage resistor (30; 41); the piezoelectric actuator (2) comprising a positive external electrode (18), a negative external electrode (20) and a piezoelectric stack (10);
   the piezoelectric stack (10) including a plurality of piezoelectric layers (12), a first population of internal electrodes, and a second population of internal electrodes, wherein the first population of internal electrodes connects to the positive external electrode (18) to create a population of positive internal electrodes (14) and the second population of internal electrodes connects to the negative external electrode (20) to create a population of negative internal electrodes (16), and wherein the positive and negative internal electrodes (18, 20) interdigitate along the length of the piezoelectric stack (10), with a piezoelectric layer (12) there between; and **characterized in that**
   the leakage resistor (30; 41) comprises a film of electrically resistive material overlying an exposed electrode face of the piezoelectric actuator (2) and in direct contact with at least one piezoelectric layer (12), positive internal electrode (14), and negative internal electrode (16) of the piezoelectric stack (10), such that charge stored across the at least one piezoelectric layer (12), positive internal electrode (14), and negative internal electrode (16) is dissipated through the electrically resistive material.

2. The piezoelectric actuator assembly (1) of Claim 1, wherein the film of electrically resistive material has a resistance of approximately 1 M$\Omega$.

3. The piezoelectric actuator assembly (1) of Claim 1 or Claim 2, wherein the electrically resistive material has a resistivity of approximately 10 G$\Omega$/square.

4. The piezoelectric actuator assembly (1) of any preceding claim, wherein the film of electrically resistive material comprises a resistive material selected from a ruthenium compound.

5. The piezoelectric actuator assembly (1) of Claim 4, wherein the resistive material is selected from barium ruthenate and ruthenium oxide.

6. The piezoelectric actuator assembly (1) of Claim 5, wherein the ruthenium compound is ruthenium oxide.

7. The piezoelectric actuator assembly (1) of any preceding claim, wherein the film of electrically resistive material is 10 to 25 $\mu$m thick.

8. The piezoelectric actuator assembly (1) of Claim 7, wherein the film of electrically resistive material is 15 to 20 $\mu$m thick.

9. The piezoelectric actuator assembly (1) of any preceding claim, wherein the film of electrically resistive material has an area of 60 to 100 mm$^2$.

10. The piezoelectric actuator assembly of Claim 9, wherein the film of electrically resistive material has an area of approximately 81 mm$^2$.

11. The piezoelectric actuator assembly (1) of Claim 10, wherein the film of electrically resistive material is approximately rectangular and has a width of approximately 4.5 mm and a length of approximately 18 mm.

12. The piezoelectric actuator assembly (1) of any preceding claim, wherein the power generated by the dissipation of charge across the electrically resistive material is approximately 0.5 mW/mm$^2$.

13. The piezoelectric actuator assembly (1) of any preceding claim, further comprising positive and negative actuator termini (22, 24) connectable to the positive and negative external electrodes (18, 20), respectively, and which are capable of receiving an electrical signal from a power supply means.

14. The piezoelectric actuator assembly (1) of any preceding claim, for use in a fuel injection (4) of an internal combustion engine.

**15.** A fuel injector (4) for use in an internal combustion engine, comprising a valve needle (5) for controlling injection of fuel into the engine and a piezoelectric actuator assembly (1) as claimed in any of Claims 1 to 14 for controlling movement of the valve needle (5).

**16.** A method for constructing a piezoelectric actuator assembly (1) having a leakage resistor (30; 41) comprising a film of electrically resistive material, which comprises:

> providing a piezoelectric stack (10), the piezoelectric stack (10) including a plurality of piezoelectric layers (12) separated by a plurality of internal electrodes, and having an exposed electrode face (32);
> printing a layer of electrically resistive ink onto the surface of the
> exposed electrode face (32) of the piezoelectric stack (10), the electrically resistive ink comprising an electrically resistive material and an organic liquid; and
> heating to evaporate the organic liquid, thereby forming a film of electrically resistive material.

**17.** The method of Claim 16, further comprising trimming the film of electrically resistive material to a desired size so as to produce a leakage resistor (30; 41) having a predetermined resistance.

**18.** The method of Claim 16 or Claim 17, wherein the resistance of the film of electrically resistive material is approximately 1 MΩ.

**19.** The method of any of Claims 16 to 18, wherein the electrically resistive material has a resistivity of approximately 10 GΩ/square.

**20.** The method of any of Claims 16 to 19, wherein the electrically resistive ink is printed onto an area of 60 to 100 mm$^2$.

**21.** The method of any of Claims 16 to 20, wherein the electrically resistive ink is printed onto an area of approximately 81 mm$^2$.

**22.** The method of Claim 20 or Claim 21, wherein the electrically resistive ink is printed in the shape of a rectangle.

**23.** The method of any of Claims 16 to 22, wherein the film of electrically resistive material is 10 to 25 $\mu$m thick.

**24.** The method of Claim 23, wherein the film of electrically resistive material is 15 to 20 $\mu$m thick.

**25.** The method of any of Claims 16 to 24, wherein the electrically resistive material is a ruthenium compound, preferably ruthenium oxide.

**26.** The method of Claim 16 or Claim 17, for making a piezoelectric actuator assembly (1) according to any of Claims 1 to 14.

**Patentansprüche**

**1.** Piezoelektrische Aktoranordnung (1), umfassend:

> einen piezoelektrischen Aktor (2) und
> einen Isolationswiderstand (30; 41),

wobei der piezoelektrische Aktor (2) eine positive Außenelektrode (18), eine negative Außenelektrode (20) und einen piezoelektrischen Stapel (10) umfasst;
wobei der piezoelektrische Stapel (10) eine Vielzahl von piezoelektrischen Schichten (12), eine erste Population von Innenelektroden und eine zweite Population von Innenelektroden aufweist, wobei die erste Population von Innenelektroden mit der positiven Außenelektrode (18) verbunden ist, um eine Population positiver Innenelektroden (14) zu bilden, und die zweite Population von Innenelektroden mit der negativen Außenelektrode (20) verbunden ist, um eine Population negativer Innenelektroden (16) zu bilden, und wobei die positiven und negativen Innenelektroden (18, 20) entlang der Länge des piezoelektrischen Stapels (10) mit einer piezoelektrischen Schicht (12) zwischen ihnen ineinandergreifen; und **dadurch gekennzeichnet, dass** der Isolationswiderstand (30; 41) einen Film aus mit elektrischem Widerstand behaftetem Material umfasst, der eine freiliegende Elektrodenseite des piezoelektrischen Aktors (2) überlagert und mit wenigstens einer piezoelektrischen Schicht (12), positiven Innenelektrode (14) und negativen Innenelektrode (16) des piezoelektrischen Stapels (10) in direktem Kontakt ist, so dass auf der wenigstens einen piezoelektrischen Schicht (12), positiven Innenelektrode (14) und negativen Innenelektrode (16) gespeicherte Ladung durch das mit elektrischem Widerstand behaftete Material abgeleitet wird.

2. Piezoelektrische Aktoranordnung (1) nach Anspruch 1, bei der der Film aus mit elektrischem Widerstand behaftetem Material einen Widerstand von etwa 1 MΩ hat.

3. Piezoelektrische Aktoranordnung (1) nach Anspruch 1 oder Anspruch 2, bei der das mit elektrischem Widerstand behaftete Material einen spezifischen Widerstand von etwa 10 GΩ/Quadrat hat.

4. Piezoelektrische Aktoranordnung (1) nach einem der vorhergehenden Ansprüche, bei der der Film aus mit elektrischem Widerstand behaftetem Material ein aus einer Rutheniumverbindung ausgewähltes Widerstandsmaterial umfasst.

5. Piezoelektrische Aktoranordnung (1) nach Anspruch 4, bei der das Widerstandsmaterial aus Bariumruthenat und Rutheniumoxid ausgewählt ist.

6. Piezoelektrische Aktoranordnung (1) nach Anspruch 5, bei der die Rutheniumverbindung Rutheniumoxid ist.

7. Piezoelektrische Aktoranordnung (1) nach einem der vorhergehenden Ansprüche, bei der der Film aus mit elektrischem Widerstand behaftetem Material 10 bis 25 $\mu$m dick ist.

8. Piezoelektrische Aktoranordnung (1) nach Anspruch 7, bei der der Film aus mit elektrischem Widerstand behaftetem Material 15 bis 20 $\mu$m dick ist.

9. Piezoelektrische Aktoranordnung (1) nach einem der vorhergehenden Ansprüche, bei der der Film aus mit elektrischem Widerstand behaftetem Material eine Fläche von 60 bis 100 mm$^2$ hat.

10. Piezoelektrische Aktoranordnung nach Anspruch 9, bei der der Film aus mit elektrischem Widerstand behaftetem Material eine Fläche von etwa 81 mm$^2$ hat.

11. Piezoelektrische Aktoranordnung (1) nach Anspruch 10, bei der der Film aus mit elektrischem Widerstand behaftetem Material etwa rechteckig ist und eine Breite von etwa 4,5 mm und eine Länge von etwa 18 mm hat.

12. Piezoelektrische Aktoranordnung (1) nach einem der vorhergehenden Ansprüche, bei der die durch die Ladungsableitung über das mit elektrischem Widerstand behaftete Material erzeugte Leistung etwa 0,5 mW/mm$^2$ beträgt.

13. Piezoelektrische Aktoranordnung (1) nach einem der vorhergehenden Ansprüche, ferner umfassend positive und negative Aktoranschlüsse (22, 24), die mit den positiven bzw. negativen Außenelektroden (18, 20) verbunden werden können und die ein elektrisches Signal von einem Stromversorgungsmittel erhalten können.

14. Piezoelektrische Aktoranordnung (1) nach einem der vorhergehenden Ansprüche zur Verwendung in einer Kraftstoffeinspritzung (4) einer Verbrennungskraftmaschine.

15. Einspritzdüse (4) zur Verwendung in einer Verbrennungskraftmaschine, umfassend eine Ventilnadel (5) zum Steuern der Kraftstoffeinspritzung in den Motor und eine piezoelektrische Aktoranordnung (1) nach einem der Ansprüche 1 bis 14 zum Steuern der Bewegung der Ventilnadel (5).

16. Verfahren zur Herstellung einer piezoelektrischen Aktoranordnung (1) mit einem Isolationswiderstand (30; 41), umfassend einen Film aus mit elektrischem Widerstand behaftetem Material, das Folgendes umfasst:

Bereitstellen eines piezoelektrischen Stapels (10), wobei der piezoelektrische Stapel (10) eine Vielzahl von piezoelektrischen Schichten (12) aufweist, die durch eine Vielzahl von Innenelektroden getrennt sind, und eine freiliegende Elektrodenseite (32) hat,
Aufdrucken einer Schicht aus mit elektrischem Widerstand behafteter Farbe auf die Oberfläche der freiliegenden Elektrodenseite (32) des piezoelektrischen Stapels (10), wobei die mit elektrischem Widerstand behaftete Farbe ein mit elektrischem Widerstand behaftetes Material und eine organische Flüssigkeit umfasst, und

Erwärmen zum Verdunsten der organischen Flüssigkeit, wodurch ein Film aus mit elektrischem Widerstand behaftetem Material gebildet wird.

17. Verfahren nach Anspruch 16, ferner umfassend das Beschneiden des Films aus mit elektrischem Widerstand behaftetem Material auf eine gewünschte Größe, um einen Isolationswiderstand (30; 41) mit einem vorbestimmten Widerstand herzustellen.

18. Verfahren nach Anspruch 16 oder Anspruch 17, bei dem der Widerstand des Films aus mit elektrischem Widerstand behaftetem Material etwa 1 MΩ beträgt.

19. Verfahren nach einem der Ansprüche 16 bis 18, bei dem das mit elektrischem Widerstand behaftete Material einen spezifischen Widerstand von etwa 10 GΩ/Quadrat hat.

20. Verfahren nach einem der Ansprüche 16 bis 19, bei dem die mit elektrischem Widerstand behaftete Farbe auf eine Fläche von 60 bis 100 mm$^2$ aufgedruckt wird.

21. Verfahren nach einem der Ansprüche 16 bis 20, bei dem die mit elektrischem Widerstand behaftete Farbe auf eine Fläche von etwa 81 mm$^2$ aufgedruckt wird.

22. Verfahren nach Anspruch 20 oder Anspruch 21, bei dem die mit elektrischem Widerstand behaftete Farbe in der Form eines Rechtecks aufgedruckt wird.

23. Verfahren nach einem der Ansprüche 16 bis 22, bei dem der Film aus mit elektrischem Widerstand behaftetem Material 10 bis 25 $\mu$m dick ist.

24. Verfahren nach Anspruch 23, bei dem der Film aus mit elektrischem Widerstand behaftetem Material 15 bis 20 $\mu$m dick ist.

25. Verfahren nach einem der Ansprüche 16 bis 24, bei dem das mit elektrischem Widerstand behaftete Material eine Rutheniumverbindung, vorzugsweise Rutheniumoxid, ist.

26. Verfahren nach Anspruch 16 oder Anspruch 17 zum Herstellen einer piezoelektrischen Aktoranordnung (1) nach einem der Ansprüche 1 bis 14.

**Revendications**

1. Ensemble formant actionneur piézo-électrique (1), comprenant :

   un actionneur piézo-électrique (2) ; et
   une résistance de fuite (30 ; 41);
   l'actionneur piézo-électrique (2) comprenant une électrode externe positive (18), une électrode externe négative (20) et un empilement piézo-électrique (10) ;
   l'empilement piézo-électrique (10) incluant une pluralité de couches piézo-électriques (12), une première population d'électrodes internes, et
   une seconde population d'électrodes internes, dans lequel la première population d'électrodes internes est connectée à l'électrode externe positive (18) pour créer une population d'électrodes internes positives (14) et la seconde population d'électrodes internes est connectée à l'électrode externe négative (20) pour créer une population d'électrodes internes négatives (16), et dans lequel les électrodes internes positives et négatives (18, 20) sont interdigitées le long de la longueur de l'empilement piézo-électrique (10) avec une couche piézo-électrique (12) entre elles ; et

   **caractérisé en ce que**
   la résistance de fuite (30 ; 41) comprend un film de matériau électriquement résistif qui recouvre une face d'électrode exposée de l'actionneur piézo-électrique (2) et qui est en contact direct avec au moins une couche piézo-électrique (12), avec l'électrode interne positive (14), et avec l'électrode interne négative (16) de l'empilement piézo-électrique (10), de sorte qu'une charge stockée dans ladite au moins une couche piézo-électrique (12), dans l'électrode interne positive (14), et dans l'électrode interne négative (16) est dissipée via le matériau électriquement résistif.

**2.** Ensemble formant actionneur piézo-électrique (1) selon la revendication 1, dans lequel le film de matériau électriquement résistif possède une résistance d'approximativement 1 MΩ.

**3.** Ensemble formant actionneur piézo-électrique (1) selon la revendication 1 ou 2, dans lequel le matériau électriquement résistif présente une résistivité d'approximativement 10 GΩ/carré.

**4.** Ensemble formant actionneur piézo-électrique (1) selon l'une quelconque des revendications précédentes, dans lequel le film de matériau électriquement résistif comprend un matériau résistif choisi parmi des composés au ruthénium.

**5.** Ensemble formant actionneur piézo-électrique (1) selon la revendication 4, dans lequel le matériau résistif est choisi parmi le ruthénate de baryum et l'oxyde de ruthénium.

**6.** Ensemble formant actionneur piézo-électrique (1) selon la revendication 5, dans lequel le composé au ruthénium est de l'oxyde de ruthénium.

**7.** Ensemble formant actionneur piézo-électrique (1) selon l'une quelconque des revendications précédentes, dans lequel le film de matériau électriquement résistif a une épaisseur de 10 à 25 μm.

**8.** Ensemble formant actionneur piézo-électrique (1) selon la revendication 7, dans lequel le film de matériau électriquement résistif a une épaisseur de 15 à 20 μm.

**9.** Ensemble formant actionneur piézo-électrique (1) selon l'une quelconque des revendications précédentes, dans lequel le film de matériau électriquement résistif possède une aire de 60 à 100 mm$^2$.

**10.** Ensemble formant actionneur piézo-électrique selon la revendication 9, dans lequel le film de matériau électriquement résistif possède une aire d'approximativement 81 mm$^2$.

**11.** Ensemble formant actionneur piézo-électrique (1) selon la revendication 10, dans lequel le film de matériau électriquement résistif est approximativement rectangulaire et a une largeur d'approximativement 4,5 mm et une longueur d'approximativement 18 mm.

**12.** Ensemble formant actionneur piézo-électrique (1) selon l'une quelconque des revendications précédentes, dans lequel la puissance générée par la dissipation de charge à travers le matériau électriquement résistif est approximativement 0,5 mW/mm$^2$.

**13.** Ensemble formant actionneur piézo-électrique (1) selon l'une quelconque des revendications précédentes, comprenant en outre des bornes d'actionneur positive et négative (22, 24) à connecter aux électrodes externes positive et négative (18, 20) respectivement, et qui sont capables de recevoir un signal électrique depuis des moyens d'alimentation de puissance.

**14.** Ensemble formant actionneur piézo-électrique (1) selon l'une quelconque des revendications précédentes, destiné à être utilisé dans un injecteur de carburant (4) d'un moteur à combustion interne.

**15.** Injecteur de carburant (4) destiné à être utilisé dans un moteur à combustion interne, comprenant une aiguille de valve (5) pour commander l'injection de carburant dans le moteur et un ensemble formant actionneur piézo-électrique (1) selon l'une quelconque des revendications 1 à 14 pour commander le mouvement de l'aiguille de valve (5).

**16.** Procédé pour construire un ensemble formant actionneur piézo-électrique (1) ayant une résistance de fuite (30 ; 41) qui comprend un film de matériau électriquement résistif, qui comprend les opérations consistant à :

fournir un empilement piézo-électrique (10),
l'empilement piézo-électrique (10) incluant une pluralité de couches piézo-électriques (12) séparées par une pluralité d'électrodes internes, et ayant une face d'électrode exposée (32) ;
imprimer une couche d'encre électriquement résistive sur la surface de la face d'électrode exposée (32) de l'empilement piézo-électrique (10),
l'encre électriquement résistive comprenant un matériau électriquement résistif et un liquide organique ; et
chauffer pour faire évaporer le liquide organique, formant ainsi un film de matériau électriquement résistif.

**17.** Procédé selon la revendication 16, comprenant en outre de rogner le film de matériau électriquement résistif à une taille désirée de manière à produire une résistance de fuite (30 ; 41) ayant une résistance prédéterminée.

**18.** Procédé selon la revendication 16 ou 17, dans lequel la résistance du film de matériau électriquement résistif est approximativement 1 MΩ.

**19.** Procédé selon l'une quelconque des revendications 16 à 18, dans lequel le matériau électriquement résistif a une résistivité d'approximativement 10 GΩ/carré.

**20.** Procédé selon l'une quelconque des revendications 16 à 19, dans lequel l'encre électriquement résistive est imprimée sur une aire de 60 à 100 mm$^2$.

**21.** Procédé selon l'une quelconque des revendications 16 à 20, dans lequel l'encre électriquement résistive est imprimée sur une aire d'approximativement 81 mm$^2$.

**22.** Procédé selon la revendication 20 ou 21, dans lequel l'encre électriquement résistive est imprimée sous la forme d'un rectangle.

**23.** Procédé selon l'une quelconque des revendications 16 à 22, dans lequel le film de matériau électriquement résistif a une épaisseur de 10 à 25 µm.

**24.** Procédé selon la revendication 23, dans lequel le matériau électriquement résistif a une épaisseur de 15 à 20 µm.

**25.** Procédé selon l'une quelconque des revendications 16 à 24, dans lequel le matériau électriquement résistif est un composé au ruthénium, de préférence de l'oxyde de ruthénium.

**26.** Procédé selon la revendication 16 ou 17, pour réaliser un ensemble formant actionneur piézo-électrique (1) selon l'une quelconque des revendications 1 à 14.

FIG. 1

**FIG. 2**

FIG. 3

FIG. 4

+

RΩ — 31

—

A

+

RΩ

33

—

FIG. 5

18

12

14

35

37

39

16

20

10

B

FIG. 6

FIG. 7

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1174615 A
- EP 1587152 A

- DE 102004006266
- EP 1516373 A

**Non-patent literature cited in the description**

- **M.R. Haskard ; K. Pitt.** *Thick-Film Technology and Applications,* ISBN 0 901150 35 5